# EUROPEAN PATENT APPLICATION

(11) **EP 4 707 742 A1**
(43) Date of publication of application: **11.03.2026**
(21) Application number: 24198944.1
(22) Date of filing: 06.09.2024
(51) Int. Cl.: G01C 21/34, G06F 30/27, G06N 20/00, G06Q 50/40, G07C 5/00, G08G 1/00, B60W 50/12, G06N 3/08

(54) **A FLEET MANAGEMENT SYSTEM AND A METHOD FOR MONITORING AND MANAGING CO2 EMISSIONS ACROSS A FLEET OF HEAVY-DUTY VEHICLES**

(71) Applicant: Volvo Truck Corporation, 405 08 Göteborg (SE)
(72) Inventor: QUIBRIAC, Yann, 69007 Lyon (FR); RIBERO, Raphael, 69390 Millery (FR)
(74) Representative: Zacco Sweden AB

(57) **Abstract**

A fleet management system for monitoring and managing CO2 emissions across a fleet of heavy-duty vehicles, wherein the fleet management is configured to host a digital twin of each vehicle in the fleet and each digital twin is configured to model CO2 emissions for its associated vehicle, the fleet management system is configured to: receive vehicle specifications and operating conditions from each vehicle; determine a nominal CO2 emission level by applying the vehicle specifications and the operating conditions of each vehicle to its associated digital twin; receive a measured CO2 emission level from each vehicle; identify vehicles with elevated CO2 emission levels by comparing the nominal CO2 emission level with the measured CO2 emission level, and in response to a vehicle having elevated CO2 emissions determine one or more adjustive actions to reduce the CO2 emission level, and communicate said adjustive actions to the identified vehicle.

## Description

### TECHNICAL FIELD

The disclosure relates generally to fleet management systems. In particular aspects, the disclosure relates to a fleet management system and a method for monitoring and managing carbon dioxide, CO2, emissions across a fleet of heavy-duty vehicles. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Manufacturers of heavy-duty vehicles, including trucks and buses, are required to adhere to emissions standards set by regulatory authorities. These standards aim to reduce greenhouse gas emissions, particularly CO2, to reduce environmental footprint of vehicles. For trucks, the CO2 emissions are calculated at the time of manufacturing, following a standardized method known as VECTO, which stands for Vehicle Energy Consumption Calculation Tool. This calculation provides an overall CO2 emission figure for a specific vehicle production year, which is then used to assess compliance with mandatory reduction targets.

Calculating CO2 emissions at the time of manufacturing provides a snapshot of compliance but fails to account for the actual emissions generated during the vehicle's operational life. Hence, there is a need for improved monitoring systems that can track the real-time CO2 emissions of heavy-duty vehicles throughout their operational lifecycles. Such monitoring systems would enable more accurate assessments that can ensure that emissions targets are met.

### SUMMARY

According to a first aspect of the disclosure, a fleet management system for monitoring and managing carbon dioxide, CO2, emissions across a fleet of heavy-duty vehicles is disclosed. The fleet management system comprises a communication interface configured for communication with the vehicles, and computing circuitry and a storage medium for hosting a digital twin of each vehicle in the fleet, where each digital twin is configured to model CO2 emissions for its associated vehicle. The fleet management system is configured to receive vehicle specifications and operating conditions from each vehicle, and determine a nominal CO2 emission level for each vehicle by applying the vehicle specifications and the operating conditions of each vehicle to its digital twin. The fleet management system is further configured receive a measured CO2 emission level from each vehicle, and identify vehicles with elevated CO2 emission levels by comparing the nominal CO2 emission level with the measured CO2 emission level. In response to a vehicle having elevated CO2 emissions, the fleet management system is configured to determine one or more adjustive actions to reduce the CO2 emission level of the identified vehicle, and communicate said one or more adjustive actions to the identified vehicle. The first aspect of the disclosure may seek to develop an improved fleet management system that can monitor and manage CO2 emissions across a fleet of heavy-duty vehicles in real time. A technical benefit may include the ability to identify vehicles with elevated CO2 emission levels based on their vehicle specifications and operating conditions, and to determine one or more adjustive actions to reduce these emissions. Hence, this approach may permit a higher nominal CO2 emission level when justified by specific vehicle specifications and operating conditions, offering a benefit over an approach that only considers average emissions across the fleet.

Optionally in some examples, including in at least one preferred example, the one or more adjustive actions comprise an instruction to the identified vehicle to reduce its CO2 emission level. A technical benefit may include reduced computing requirements, as the vehicle itself handles the specifics of determining exactly what action to take. Another technical benefit may include that it allows the vehicle operator to prioritize certain actions over others, thereby avoiding those actions that may disrupt current usage of the vehicle.

Optionally in some examples, including in at least one preferred example, the fleet management system is further configured to receive operating settings, and wherein determining one or more adjustive actions comprises determining adjusted operating settings that reduce CO2 emission levels. The operating settings comprises at least one of vehicle speed, gearbox operation mode, gear shifting strategy, engine torque, cruise control settings, climate control settings, power take-off speed, and idle time settings. A technical benefit may include that the fleet management system has access to the vehicle's operating settings, thereby has the ability to determine adjustive actions that can reduce CO2 emissions to a specified level or by a designated amount.

Optionally in some examples, including in at least one preferred example, the fleet management system is further configured to determine the one or more adjustive actions by selecting one or more adjustive actions from a set of adjustive actions that are known to reduce CO2 emission levels. The set of adjustive actions may comprise at least one of limiting vehicle speed, mandating automatic mode in robotized gearboxes, activating eco-strategy gear shifting in robotized gearboxes, reducing engine torque, activating predictive cruise control, lowering climate control settings, decreasing power take-off speed, and reducing idle time. A technical benefit may include reduced computing requirements on the fleet management system, as selecting from a predefined set of adjustive actions eliminates the need for complex computational analysis.

Optionally in some examples, including in at least one preferred example, the fleet management system is configured to determine one or more adjustive actions by applying the digital twin to identify operating settings that contribute to the elevated CO2 emission value. A technical benefit may include the ability to test one or more adjustive actions on the digital twin before deploying them to the vehicle.

Optionally in some examples, including in at least one preferred example, the fleet management system is configured to identify vehicles with elevated CO2 emission levels by determining whether the measured CO2 emission level exceed the nominal CO2 emission level by a predetermined threshold value. A technical benefit may include improved ability to identify vehicles based on how much they exceed a nominal CO2 emission level, thereby providing a useful tool to manage aggregate CO2 emission levels across the fleet of heavy-duty vehicles.

Optionally in some examples, including in at least one preferred example, the fleet management system is configured to set the nominal CO2 emission level to ensure that the nominal CO2 emission level across the fleet of heavy-duty vehicles collectively meets an aggregate CO2 emission limit. A technical benefit may include more effective control over aggregate CO2 emission levels across the fleet of heavy-duty vehicles.

Optionally in some examples, including in at least one preferred example, the vehicle specifications comprise at least one of vehicle chassis configuration, trailer configuration, vehicle weight, engine type, gearbox configuration, suspension system configuration, braking system configuration, and tire inflate system or any combination thereof.

Optionally in some examples, including in at least one preferred example, the operating conditions comprise at least one of load weight, vehicle usage, route topography, tire pressure, engine coolant temperature, engine oil temperature, weather data, dust levels, particle levels, and vehicle application/usage (e.g., transport, construction, waste management, public transport, mining, and logging).

Optionally in some examples, including in at least one preferred example, the digital twin comprises a machine learning model that is trained on a dataset comprising at least one of: vehicle specifications, operating conditions, and CO2 emission levels; and vehicle specifications, operating conditions, operating settings, and CO2 emission levels. The machine learning model may be a neural network or a convolutional neural network. A technical benefit may include enhanced accuracy in determining CO2 emission levels as machine learning models of this type work well with larger multivariate datasets.

Optionally in some examples, including in at least one preferred example, the fleet management system is further configured to receive operating settings, determine an expected CO2 emission level for each vehicle by applying the vehicle specifications, the operating conditions, and the operating settings of each vehicle to its digital twin, and detect a mismatch between an expected CO2 emission level and the measured CO2 emission level, and in response the mismatch request that the vehicle reports for vehicle service by sending a message from the fleet management system to the vehicle. A technical benefit may include the ability to detect elevated CO2 emission levels that do not depend on operational settings and may require vehicle service, such as a clogged air filter or oil filter.

According to a second aspect of the disclosure, a control unit in a heavy-duty vehicle configured for coordination with a fleet management system is disclosed. The fleet management system comprises a digital twin configured to determine a nominal CO2 emission level based on vehicle specifications and operating conditions of the heavy-duty vehicle. The control unit is configured to obtain the vehicle specifications and the operating conditions of the heavy-duty vehicle, and obtain a CO2 emission level from an exhaust system sensor of the heavy-duty vehicle. The control unit is further configured to send the vehicle specifications, the operating conditions and the measured CO2 emission level to the fleet management system, whereby the fleet management system is configured to determine and communicate one or more adjustive actions in response to the measured CO2 emission level being elevated in comparison to a nominal CO2 emission level. The control unit is further configured to receive the one or more adjustive actions and apply the one or more adjustive actions to the operating settings, thereby achieving a reduced CO2 emission level. The second aspect of the disclosure may provide a vehicle for coordination with an improved fleet management system that can track and manage CO2 emissions across a fleet of vehicles in real time. A technical benefit may include the ability to apply one or more adjustive actions to reduce CO2 emission levels, thereby providing a control unit compatible with a fleet management system that monitors and manages CO2 emissions in real time.

Optionally in some examples, including in at least one preferred example, the one or more adjustive actions comprises an instruction to reduce CO2 emission level, and wherein applying the instruction, the control unit is configured to select one or more adjustive actions from a set of adjustive actions that are known to reduce CO2 emission levels. A technical benefit may include the ability to select adjustive actions locally at the vehicle, thus allowing the operator to prioritize actions, thereby avoiding those that may disrupt current usage of the vehicle.

According to a third aspect of the disclosure, a method for monitoring and managing carbon dioxide, CO2, emissions across a fleet of heavy-duty vehicles is disclosed. The method utilizes a digital twin to model CO2 emissions of each vehicle in the fleet. The method comprises receiving vehicle specifications and operating conditions from each vehicle, and determining a nominal CO2 emission level for each vehicle by applying the vehicle specifications and the operating conditions of each vehicle to its digital twin. The method further comprises receiving measured CO2 emission level from each vehicle, and identifying vehicles with elevated CO2 emission levels by comparing the nominal CO2 emission level with the measured CO2 emission level. In response to a vehicle having elevated CO2 emissions, the method comprises determining one or more adjustive actions to reduce the CO2 emission level of the identified vehicle, and communicating said adjustive actions to the identified vehicle. The third aspect of the disclosure may seek to develop an improved method for monitoring and managing CO2 emissions across a fleet of heavy-duty vehicles in real time. A technical benefit may include the ability to identify vehicles with elevated CO2 emission levels based on their vehicle specifications and operating conditions, and to determine one or more adjustive actions to reduce these emissions. Hence, this approach may permit a higher nominal CO2 emission level when justified by specific vehicle specifications and operating conditions, offering a benefit over an approach that only considers average emissions across the fleet.

Optionally in some examples, including in at least one preferred example, the one or more adjustive actions comprise an instruction to the identified vehicle to reduce its CO2 emission level. A technical benefit may include reduced computing requirements, as the vehicle itself handles the specifics of determining exactly what action to take. Another technical benefit may include that it allows the vehicle operator to prioritize certain actions over others, thereby avoiding those actions that may disrupt current usage of the vehicle.

Optionally in some examples, including in at least one preferred example, receiving further comprises receiving operating settings from each vehicle, and wherein determining one or more adjustive actions comprises determining adjusted operating settings that reduce CO2 emission levels. The operating settings comprises at least one of vehicle speed, gearbox operation mode, gear shifting strategy, engine torque, cruise control settings, climate control settings, power take-off speed, and idle time settings or any combination thereof. A technical benefit may include having access to the vehicle's operating settings, thereby having the ability to determine adjustive actions that can reduce CO2 emissions to a specified level or by a designated amount.

Optionally in some examples, including in at least one preferred example, determining the one or more adjustive actions comprises selecting one or more adjustive actions from a set of adjustive actions that are known to reduce CO2 emission levels. The set of adjustive actions may comprise at least one of limiting vehicle speed, mandating automatic mode in robotized gearboxes, activating eco-strategy gear shifting in robotized gearboxes, reducing engine torque, activating predictive cruise control, lowering climate control settings, decreasing power take-off speed, and reducing idle time or any combination thereof. A technical benefit may include reduced computing requirements on the fleet management system, as selecting from a predefined set of adjustive actions eliminates the need for complex computational analysis.

Optionally in some examples, including in at least one preferred example, determining the one or more adjustive actions comprises applying the digital twin to identify operating settings that contribute to the elevated CO2 emission value. A technical benefit may include the ability to test the one or more adjustive actions on the digital twin before deploying them to the vehicle.

Optionally in some examples, including in at least one preferred example, identifying vehicles with elevated CO2 emission levels comprises determining whether the measured CO2 emission level exceed the target CO2 emission level by a predetermined threshold value. A technical benefit may include improved ability to identify vehicles based on how much they exceed a nominal CO2 emission level, thereby providing an improved method for managing aggregate CO2 emission levels across the fleet of heavy-duty vehicles.

Optionally in some examples, including in at least one preferred example, the digital twin comprises a machine learning model that is trained on a dataset comprising at least one of: vehicle specifications, operating conditions, and CO2 emission levels; and vehicle specifications, operating conditions, operating settings, and CO2 emission levels. The machine learning model may be a neural network or a convolutional neural network. A technical benefit may include enhanced accuracy in determining CO2 emission levels as machine learning models of this type work well with larger multivariate datasets.

Optionally in some examples, including in at least one preferred example, the method further comprises determining an expected CO2 emission level for each vehicle by applying the vehicle specifications, the operating conditions, and the operating settings of each vehicle to its associated digital twin, detecting a mismatch between the expected CO2 emission level and the measured CO2 emission level, and in response to the detected mismatch requesting that the vehicle reports for vehicle service by sending a message from the fleet management system to the vehicle. A technical benefit may include the ability to detect elevated CO2 emission levels that do not depend on operational settings and may require vehicle service, such as a clogged air filter or oil filter.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein. There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
FIG. 1 illustrates an example of a fleet management system for monitoring and managing CO2 emissions across a fleet of heavy-duty vehicles.
FIG. 2 is an alternative schematic diagram of FIG. 1 describing the architecture of the fleet management system and heavy-duty vehicles.
FIG. 3 is a flow chart of a method for monitoring and managing carbon dioxide, CO2, emissions across a fleet of heavy-duty vehicles, according to an example.
FIG. 4A schematically illustrates a control unit.
FIG. 4B shows an example of a computer program product.
FIG. 5 is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

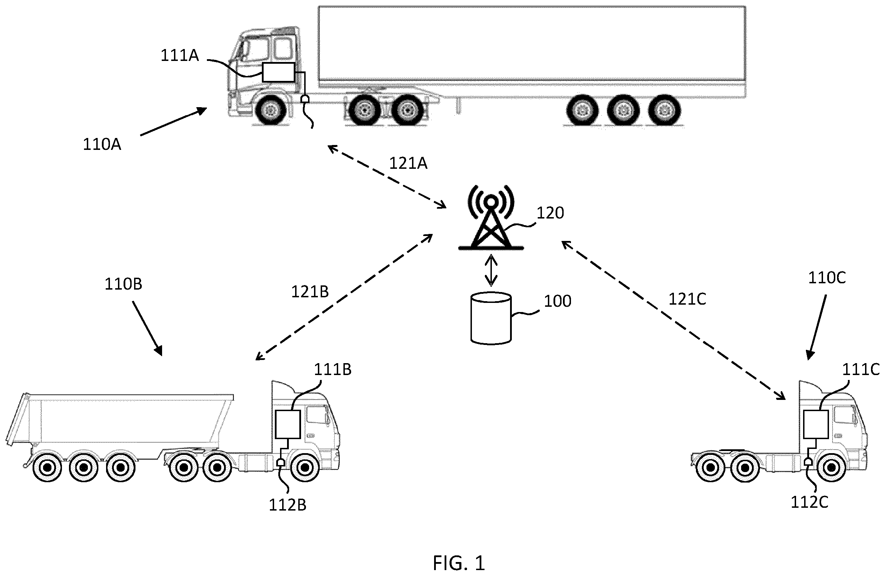

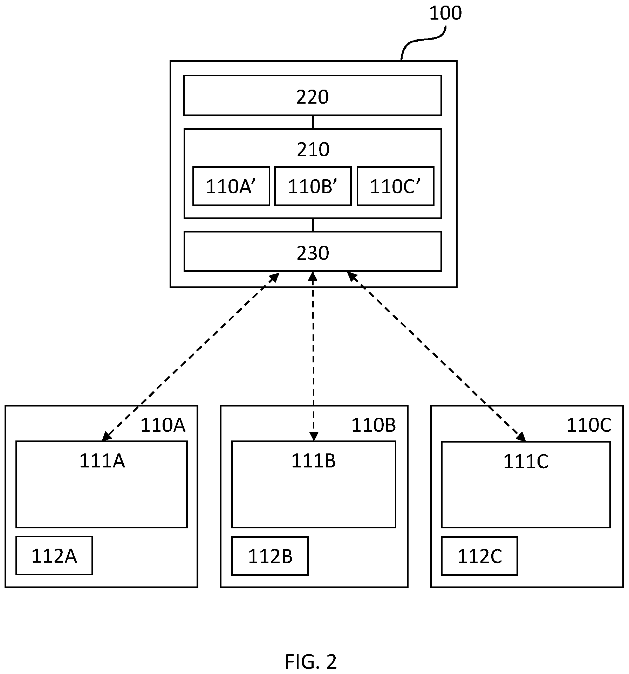

FIGS. 1-2 illustrate a first aspect of the disclosure relating to a fleet management system 100 for monitoring and managing carbon dioxide (CO2) emissions across a fleet of heavy-duty vehicles 110A, 110B, 110C. While FIG. 1 provides a general overview of a fleet management system connected to a fleet of heavy-duty vehicles, FIG. 2 offers a more detailed block diagram of the architecture of the fleet management system and the connected heavy-duty vehicles.

The fleet management system 100 comprises a communication interface 230, configured to enable communication with vehicles 110A, 110B, 110C of the fleet. The communication interface 230 is configured for bi-directional communication with vehicles 110A, 110B, 110C of the fleet, to allow real-time data exchange and remote management of vehicle functions. Typically, the vehicles are connected to the fleet management system 100 via wireless communication links 121A, 121B, 121C that may utilize an existing wireless access network 120, e.g., 3GPP. In some instances, particularly in remote areas lacking network coverage, satellite communication may also be employed.

The fleet management system 100 can be implemented in a number of ways, for example, on a server in a central node, in a distributed network where a plurality of computing resources are combined, or deployed virtually using cloud services to enhance flexibility and scalability. The fleet management system 100 comprises computing circuitry 210 and a storage medium 220 for hosting a digital twin 110A', 110B', 110C' of each vehicle in the fleet, where each digital twin is configured to model CO2 emissions for its associated vehicle. Hosting involves allocating sufficient storage and computing resources to each digital twin. These resources may be shared among the digital twins 110A', 110B', 110C' using methods such as time-division multiplexing.

The fleet management system is configured to receive vehicle specifications and operating conditions from each vehicle 110A, 110B, 110C. The vehicle specifications describe fixed attributes of a vehicle model that affect CO2 emission levels and may include vehicle weight, length, height, width, chassis configuration, trailer configuration, engine type, fuel consumption, gearbox configuration, suspension system configuration, braking system configuration, tire inflation system, among others. The operating conditions describe the environment in which the vehicle operates and may include load weight, frequency of use, route topography, road surface, traffic conditions, tire pressure, engine coolant and oil temperatures, weather conditions, altitude, levels of dust and particles, among others. The operating conditions may also cover the vehicle's application/usage, such as transport, construction, waste management, public transport, mining, and logging. It should be noted that vehicle specifications, such as engine type and gearbox configuration, are typically static and only need to be received once, whereas operating conditions, like engine coolant and oil temperatures, or weather data, are more dynamic and typically need to be received continuously.

The fleet management system 100 is further configured determine a nominal CO2 emission level for each vehicle 110A, 110B, 110C by applying the vehicle specifications and the operating conditions of each vehicle to its digital twin 110A', 110B', 110C'. A digital twin is a virtual model that accurately reflects the real-time status, operating conditions, and performance of a physical counterpart, thereby enabling optimization of the physical counterpart by performing simulations and adjustments on the digital twin. Depending on their complexity, digital twins can range from simple mathematical models that require minimal computational power to highly sophisticated models that demand significant computational resources. The disclosure, according to the first aspect, is designed to function with both basic models and more advanced models of digital twins. Aspects detailing the implementation of the digital twins and how a nominal CO2 emission level for each vehicle 110A, 110B, 110C is determined will appear in subsequent parts of this document.

The fleet management system 100 is also configured to receive a measured CO2 emission level from each vehicle 110A, 110B, 110C. The measured CO2 emission level is typically received continuously, but can be obtained at different intervals based on the required level of monitoring precision. The measured CO2 emission level reflects the actual emissions and can be compared to the nominal CO2 emission level that reflect an expected or a target CO2 emission levels for certain vehicle specifications and operating conditions. By comparing the nominal CO2 emission level with the measured CO2 emission level, the fleet management system 100 can identify vehicles with elevated CO2 emission levels. In one example, the fleet management system 100 is configured to identify vehicles with elevated CO2 emission levels by determining whether the measured CO2 emission level exceed the nominal CO2 emission level by a predetermined threshold value. An advantage of using a threshold value includes improved ability to identify vehicles based on how much they exceed a nominal CO2 emission level. This could serve as a useful tool for managing aggregate CO2 emissions across the fleet of heavy-duty vehicles 110A, 110B, 110C, as it enables vehicles to be classified into different groups according to their exceedance of the nominal CO2 emission levels.

Lastly, and in response to a vehicle having elevated CO2 emissions, the fleet management system 100 is configured to determine one or more adjustive actions to reduce the CO2 emission level of the identified vehicle, and communicate said one or more adjustive actions to the identified vehicle. Determining one or more adjustive actions can be achieved in a number of ways.

In one example, the one or more adjustive actions comprise an instruction to the identified vehicle to reduce its CO2 emission level. This might involve instructions to reduce CO2 emissions to a specified level or by a designated amount. An advantage of this approach is reduced computing requirements on the fleet management system 100, as the vehicle itself handles the specifics of determining exactly what actions to take. Another advantage is that it enables vehicle operators to prioritize certain actions over others, thereby avoiding those that may disrupt current usage of the vehicle. In this example, the vehicle would typically maintain a set of locally stored adjustive actions that are known to reduce CO2 emission levels.

In another example, the fleet management system 100 is further configured to receive operating settings from the vehicle. Determining one or more adjustive actions may then comprise determining adjusted operating settings that reduce CO2 emission levels. In this approach, the adjusted operating settings are determined by the fleet management system 100. The operating settings may comprise vehicle speed, gearbox operation mode, gear shifting strategy, engine torque, cruise control settings, climate control settings, power take-off speed, and idle time settings or any other adjustable setting that affect CO2 emission levels. An advantage of this approach is that the fleet management system 100 has access to the vehicle's operating settings, thereby has the ability to determine adjustive actions that can reduce CO2 emissions to a specified level or by a designated amount.

The fleet management system 100 may be configured to determine the one or more adjustive actions by selecting one or more adjustive actions from a set of adjustive actions that are known to reduce CO2 emission levels. The set of adjustive actions may comprise limiting vehicle speed, mandating automatic mode in robotized gearboxes, activating eco-strategy gear shifting in robotized gearboxes, reducing engine torque, activating predictive cruise control, lowering climate control settings, decreasing power take-off speed, and reducing idle time or any other action that is known to reduce CO2 emission levels. A technical benefit may include reduced computing requirements on the fleet management system 100, as selecting from a predefined set of adjustive actions eliminates the need for complex computational analysis.

The fleet management system 100 may be configured to determine one or more adjustive actions by applying the digital twin to identify operating settings that contribute to the elevated CO2 emission value. An advantage of this approach is the ability to test the one or more adjustive actions on the digital twin 1 10A', 110B', 110C' before deploying them to the vehicle 110A, 110B, 110C. By this approach CO2 emissions can be reduced by a specified level or by a designated amount adjusted by first trying the adjusted operated settings on the digital twin.

In its most general form, the digital twin 110A', 110B', 110C' is a function that determines a nominal CO2 emission level based on the vehicle specifications and operating conditions of the associated vehicle. It may however in many applications also be preferable to include operating settings, as this may allow the digital twin to identify operating settings that contribute to the elevated CO2 emission value. If the number of parameters (or arguments) are few the function may be approximated using well-known methods in regression analysis and model fitting. For larger datasets, a better approach may involve that the digital twin comprises a machine learning model that has been trained on a labelled dataset comprising: 1) the vehicle specifications, the operating conditions, and CO2 emission levels, or 2) the vehicle specifications, the operating conditions, the operating settings, and CO2 emission levels. Preferably, the machine learning model may be a neural network or a convolutional neural network as these are well-suited for working with larger multivariate datasets. The trained machine learning model, once integrated into a deployment environment, may receive input in the form of vehicle specifications and operating conditions. It then applies its learned parameters to these inputs to predict an expected CO2 emission level. An advantage of using a machine learning model may include enhanced accuracy in determining CO2 emission levels as machine learning models of this type work well with larger multivariate datasets. In yet another example, the digital twin may comprise the machine learning models of both examples 1 and 2 above.

As mentioned earlier, the fleet management system 100 is configured determine a nominal CO2 emission level for each vehicle 110A, 110B, 110C by applying the vehicle specifications and the operating conditions to the digital twin 110A', 110B', 110C'. Hence, the nominal CO2 emission level should reflect the vehicle specifications and the operating conditions, but not the operating settings. For example, the nominal CO2 emission level may be the expected CO2 emission level. The nominal CO2 emission level may also be adjusted or set to ensure that the nominal CO2 emission level across the fleet of heavy-duty vehicles 110A, 110B, 110C collectively meets an aggregate CO2 emission limit. For example, if the expected CO2 emission levels of all vehicles collectively exceed the aggregate CO2 emission limit by a certain percentage, the nominal CO2 emission level may be reduced in order to comply with the aggregate CO2 emission limit.

In another example, the fleet management system 100 is further configured to receive operating settings and determine an expected CO2 emission level for each vehicle 110A, 110B, 110C by applying the vehicle specifications, the operating conditions, and the operating settings of each vehicle to its digital twin 110A', 110B', 110C'. It should be noted that the expected CO2 emission level in this case depend on the operating settings. The fleet management system 100 may then detect a mismatch between an expected CO2 emission level and the measured CO2 emission level, and in response the mismatch request that the vehicle reports for vehicle service by sending a message from the fleet management system to the vehicle. An advantage of this approach include the ability to detect elevated CO2 emission levels that do not depend on operational settings. For example, a clogged air filter or a clogged fuel filter.

FIGS. 1-2 also illustrate a second aspect of the disclosure relating to a control unit 111A, 111B, 111C in a heavy-duty vehicle 110A, 110B, 110C configured for coordination with a fleet management system 100. The fleet management system may be the fleet management system according to the first the aspects disclosure. The control unit 111A, 111B, 111C is configured to obtain the vehicle specifications and the operating conditions of the heavy-duty vehicle, and obtain a CO2 emission level from an exhaust system sensor 112A, 112 B, 112C of the heavy-duty vehicle. The exhaust system sensor measures the concentration of carbon dioxide in the exhaust gases as they exit the vehicle, providing real-time data on the CO2 emission level. The operating conditions may be obtained from various types of vehicle sensors (e.g., temperature sensors, pressure sensors, etc.), the vehicle's navigation system, and other onboard diagnostic tools or external data sources. The vehicle specification may typically be stored in an onboard computer system of the vehicle.

The control unit 111A, 111B, 111C is further configured to send the vehicle specifications, the operating conditions and the measured CO2 emission level to the fleet management system 100, whereby the fleet management system 100 is configured to determine and communicate one or more adjustive actions in response to the measured CO2 emission level being elevated in comparison to a nominal CO2 emission level. The control unit is further configured to receive the one or more adjustive actions and apply the one or more adjustive actions to the operating settings, thereby achieving a reduced CO2 emission level. An advantage of a control unit capable of applying one or more adjustive actions to reduce CO2 emission levels is that it is compatible with the requirements of a fleet management system 100 that requires real-time monitoring and management of CO2 emissions.

In some examples, the one or more adjustive actions comprises an instruction to reduce CO2 emission level, and wherein applying the instruction, the control unit is configured to select one or more adjustive actions from a set of locally stored adjustive actions that are known to reduce CO2 emission levels. The set of locally stored adjustive actions may, for example, be stored in a memory in the control unit 111A, 111B, 111C. The set of actions may comprise limiting vehicle speed, mandating automatic mode in robotized gearboxes, activating eco-strategy gear shifting in robotized gearboxes, reducing engine torque, activating predictive cruise control, lowering climate control settings, decreasing power take-off speed, and reducing idle time or any combination thereof. An advantage of selecting the one or more locally stored adjustive actions is that it allows the operator to prioritize certain actions over others, thereby avoiding those actions that may disrupt current usage of the vehicle

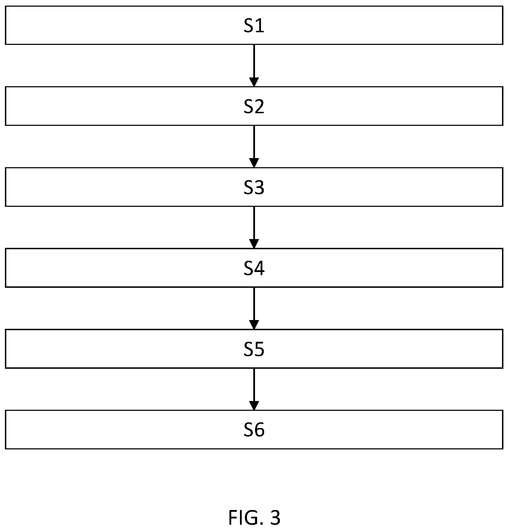

FIG. 3 illustrate a third aspect of the disclosure relating to a method for monitoring and managing carbon dioxide, CO2, emissions across a fleet of heavy-duty vehicles 110A, 110B, 110C. The method comprises receiving S 1 vehicle specifications and operating conditions, determining S2 a nominal CO2 emission level, receiving S3 a measured CO2 emission level, identifying S4 vehicles with elevated CO2 emission levels, and in response to a vehicle having elevated CO2 emissions, determining S5 one or more adjustive actions, and communicating S6 said adjustive actions. It should be noted that any of the aforementioned aspects relating to fleet management system 100 are also applicable to the method.

The method comprises receiving S 1 vehicle specifications and operating conditions from each vehicle 110A, 110B, 110C, and determining S2 a nominal CO2 emission level for each vehicle 110A, 110B, 110C by applying the vehicle specifications and the operating conditions of each vehicle to its digital twin 110A', 110B', 110C'. Note that the details regarding the digital twins and the nominal CO2 emission levels for each vehicle 110A, 110B, 110C are the same as described in the first aspect of the disclosure.

The method comprises receiving S3 a measured CO2 emission level from each vehicle 110A, 110B, 110C. Although the measured CO2 emission level is typically received continuously, it can be obtained at different intervals based on the required level of detail for the method.

The method comprises identifying S4 vehicles with elevated CO2 emission levels by comparing the nominal CO2 emission level with the measured CO2 emission level. In one example, identifying S4 vehicles with elevated CO2 emission levels comprises determining whether the measured CO2 emission level exceed the nominal CO2 emission level by a predetermined threshold value. An advantage of using a threshold value include improved ability to identify vehicles based on how much they exceed a nominal CO2 emission level.

In response to a vehicle having elevated CO2 emissions, the method comprises determining S5 one or more adjustive actions to reduce the CO2 emission level of the identified vehicle, and communicating S6 said one or more adjustive actions to the identified vehicle. Determining one or more adjustive actions can be achieved in a number of ways.

In some examples, the one or more adjustive actions comprise an instruction to the identified vehicle to reduce its CO2 emission level. This might involve instructions to reduce CO2 emissions to a specified level or by a designated amount. A technical benefit may include reduced computing requirements, as the vehicle itself handles the specifics of determining exactly what action to take. Another technical benefit may include that it allows the vehicle operator to prioritize certain actions over others, thereby avoiding those actions that may disrupt current usage of the vehicle. In this example, the vehicle would typically maintain a set of locally stored adjustive actions that are known to reduce CO2 emission levels.

In some examples, receiving S 1 further comprises receiving operating settings from each vehicle 110A, 110B, 110C, and determining S5 one or more adjustive actions comprises determining adjusted operating settings that reduce CO2 emission levels. The operating settings may comprise vehicle speed, gearbox operation mode, gear shifting strategy, engine torque, cruise control settings, climate control settings, power take-off speed, and idle time settings or any combination thereof, or any other setting that is known to reduce CO2 emission levels. An advantage of this approach is that the fleet management system 100 has access to the vehicle's operating settings, which is useful for determining adjustive actions that can reduce CO2 emissions to a specified level or by a designated amount.

In some examples, determining S5 the one or more adjustive actions comprises selecting one or more adjustive actions from a set of adjustive actions that are known to reduce CO2 emission levels. The set of adjustive actions may comprise at least one of limiting vehicle speed, mandating automatic mode in robotized gearboxes, activating eco-strategy gear shifting in robotized gearboxes, reducing engine torque, activating predictive cruise control, lowering climate control settings, decreasing power take-off speed, and reducing idle time or any combination thereof. A technical benefit may include reduced computing requirements on the fleet management system 100, as selecting from a predefined set of adjustive actions eliminates the need for complex computational analysis.

In some examples, determining S5 the one or more adjustive actions comprises applying the digital twin to identify operating settings that contribute to the elevated CO2 emission value. An advantage of this approach is the ability to test the one or more adjustive actions on the digital twin 110A', 110B', 110C' before deploying them to the vehicle 110A, 110B, 110C. By this approach CO2 emissions can be reduced by a specified level or by a designated amount by first trying the adjusted operated settings on the digital twin.

In some examples, the method further comprises determining an expected CO2 emission level for each vehicle 110A, 110B, 110C by applying the vehicle specifications, the operating conditions, and the operating settings of each vehicle to its associated digital twin 110A', 110B', 110C', detecting a mismatch between the expected CO2 emission level and the measured CO2 emission level, and in response to the detected mismatch requesting that the vehicle reports for vehicle service by sending a message from the fleet management system to the vehicle. An advantage of this approach includes the ability to detect elevated CO2 emission levels that do not depend on operational settings. For example, a clogged air filter or a clogged fuel filter.

In the following, some additional considerations to the first, second and third aspect of the disclosure will be discussed.

The basic concept is to dynamically monitor and adjust the CO2 emissions of an OEM fleet of vehicles over a defined period, aiming to stay within a global CO2 emission limit set for an OEM for a specified year. The method involves comparing the CO2 emissions of one specific truck against a significant number of other vehicles with the same configuration and similar applications, which are expected to have comparable CO2 emissions. The purpose of this comparison is to adjust vehicle functions to reduce the vehicle's CO2 emissions, aligning it with the emission range of other vehicles in the same category with similar uses. Possible outcomes of this comparison for a given vehicle include activating or deactivating functions, and tuning the behavior of some functions by adjusting parameters.

Reasons for a high CO2 emission can be: aggressive driving style or at least non-eco driving style, tire pressure, wrong parameter settings of engine, engine air filters clogged, engine fuel filters clogged, PTO over used, locking differential overused, climate control overused, windows/roof open at high speed.

Vehicle specification and operating conditions that may be used as input may comprise: vehicle chassis configuration: e.g: 4x2 tractor 520 HP; vehicle driveline configuration: diesel; vehicle gearbox configuration: robotized, automatic, manual; vehicle suspension system: semi-pneumatic, full pneumatic or mechanical; vehicle milage per day; vehicle usages: long haul, garbage trucks; vehicle driving usages: number of braking phases; compressor activation duration; air tanks configuration: number and volume; braking system configuration: disk / dumb brakes, number of valves; tires inflate system: without and with; tire pressure; trailer configuration and presence: 0 trailer, 1 trailer, 2 trailers; vehicle weight; PTI: periodical technical inspections (maintenances schedules and history); diagnostic trouble codes; environmental conditions: dust, particles, etc.; climate conditions: humidity, temperature, wind; vehicle function status; missions path and road segment types; idle time; engine running time; engine coolant temperature; and engine oil temperature.

The fleet management system may be configured for gap monitoring between the digital twin's virtual CO2 value and the measured CO2 value on a vehicle, in order to verify and trigger adaptations in system behavior: For instance, limiting systems that emit CO2 such as implementing vehicle speed limitations, inhibiting manual mode in robotized gearboxes (forcing automatic mode), activating eco strategy in robotized gearbox gear shifting, reducing engine torque, forcing the activation of predictive cruise control while driving, adjusting climate control, adjusting PTO speed, and limiting idle time.

The fleet management system acts on vehicles with high CO2 emissions in order to cut the high CO2 emitters vehicles using actions described above. Alternatively, the fleet management system may act on the entire vehicle fleet using actions described above in order to keep an entire OEM vehicle fleet under a global CO2 emission in order to meet the CO2 regulation target.

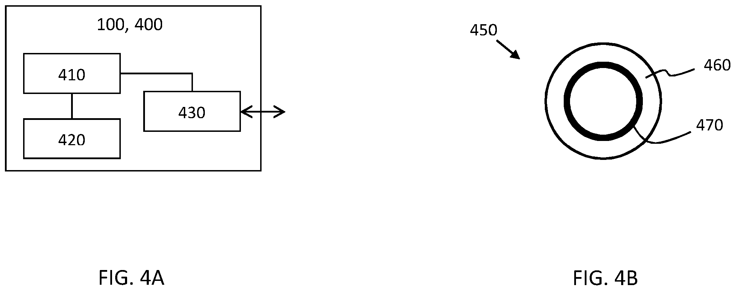

FIG. 4A schematically illustrates, in terms of a number of functional units, the components of a control unit 100, 400 according to aspects of the discussions and methods disclosed herein. Processing circuitry 210, 410 is provided using any combination of one or more of a suitable central processing unit CPU, multiprocessor, microcontroller, digital signal processor DSP, etc., capable of executing software instructions stored in a computer program product, e.g., in the form of a storage medium 220, 420. The processing circuitry 210, 410 may further be provided as at least one application specific integrated circuit ASIC, or field programmable gate array FPGA.

Particularly, the processing circuitry 210, 410 is configured to cause the control unit to perform a set of operations, or steps, such as the methods discussed in connection to FIG. 3. For example, the storage medium 220, 420 may store the set of operations, and the processing circuitry 210, 410 may be configured to retrieve the set of operations from the storage medium 420 to cause the control unit to perform the set of operations. The set of operations may be provided as a set of executable instructions. Thus, the processing circuitry 210, 410 is thereby arranged to execute methods as herein disclosed.

The storage medium 420 may also comprise persistent storage, which, for example, can be any single one or combination of magnetic memory, optical memory, solid state memory or even remotely mounted memory.

The control unit 100, 400 may further comprise an interface 230, 430 for communications with at least one external device. As such the interface 230, 430 may comprise one or more transmitters and receivers, comprising analogue and digital components and a suitable number of ports for wireline or wireless communication.

The processing circuitry 210, 410 controls the general operation of the control unit, e.g., by sending data and control signals to the interface 230, 430 and the storage medium 220, 420, by receiving data and reports from the interface 230, 430, and by retrieving data and instructions from the storage medium 220, 420. Other components, as well as the related functionality, of the control node are omitted in order not to obscure the concepts presented herein.

FIG. 4B shows an example of a computer program product. A computer readable medium 460 carrying a computer program 470 comprising program code means for performing the steps of aforementioned method when said program product is run on a computer or on processing circuitry 210, 410 of a control unit 100, 400.

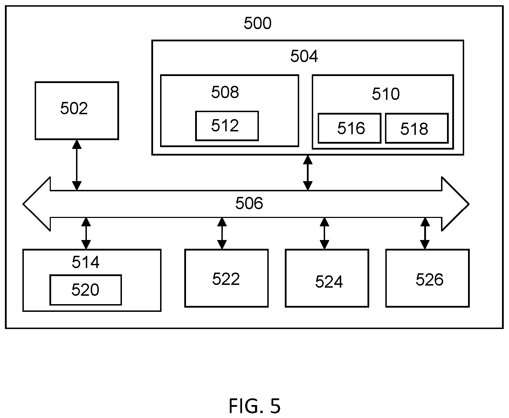

FIG. 5 is a schematic diagram of a computer system 500 for implementing examples disclosed herein. The computer system 500 is adapted to execute instructions from a computer-readable medium to perform these and/or any of the functions or processing described herein. The computer system 500 may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 500 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system 500 may comprise at least one computing device or electronic device capable of including firmware, hardware, and/or executing software instructions to implement the functionality described herein. The computer system 500 may include processing circuitry 502 (e.g., processing circuitry including one or more processor devices or control units), a memory 504, and a system bus 506. The computer system 500 may include at least one computing device having the processing circuitry 502. The system bus 506 provides an interface for system components including, but not limited to, the memory 504 and the processing circuitry 502. The processing circuitry 502 may include any number of hardware components for conducting data or signal processing or for executing computer code stored in memory 504. The processing circuitry 502 may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry 502 may further include computer executable code that controls operation of the programmable device.

The system bus 506 may be any of several types of bus structures that may further interconnect to a memory bus (with or without a memory controller), a peripheral bus, and/or a local bus using any of a variety of bus architectures. The memory 504 may be one or more devices for storing data and/or computer code for completing or facilitating methods described herein. The memory 504 may include database components, object code components, script components, or other types of information structure for supporting the various activities herein. Any distributed or local memory device may be utilized with the systems and methods of this description. The memory 504 may be communicably connected to the processing circuitry 502 (e.g., via a circuit or any other wired, wireless, or network connection) and may include computer code for executing one or more processes described herein. The memory 504 may include non-volatile memory 508 (e.g., read-only memory (ROM), erasable programmable read-only memory (EPROM), electrically erasable programmable read-only memory (EEPROM), etc.), and volatile memory 510 (e.g., random-access memory (RAM)), or any other medium which can be used to carry or store desired program code in the form of machine-executable instructions or data structures and which can be accessed by a computer or other machine with processing circuitry 502. A basic input/output system (BIOS) 512 may be stored in the non-volatile memory 508 and can include the basic routines that help to transfer information between elements within the computer system 500.

The computer system 500 may further include or be coupled to a non-transitory computer-readable storage medium such as the storage device 514, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device 514 and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device 514 and/or in the volatile memory 510, which may include an operating system 516 and/or one or more program modules 518. All or a portion of the examples disclosed herein may be implemented as a computer program 520 stored on a transitory or non-transitory computer-usable or computer-readable storage medium (e.g., single medium or multiple media), such as the storage device 514, which includes complex programming instructions (e.g., complex computer-readable program code) to cause the processing circuitry 502 to carry out actions described herein. Thus, the computer-readable program code of the computer program 520 can comprise software instructions for implementing the functionality of the examples described herein when executed by the processing circuitry 502. In some examples, the storage device 514 may be a computer program product (e.g., readable storage medium) storing the computer program 520 thereon, where at least a portion of a computer program 520 may be loadable (e.g., into a processor) for implementing the functionality of the examples described herein when executed by the processing circuitry 502. The processing circuitry 502 may serve as a controller or control system for the computer system 500 that is to implement the functionality described herein.

The computer system 500 may include an input device interface 522 configured to receive input and selections to be communicated to the computer system 500 when executing instructions, such as from a keyboard, mouse, touch-sensitive surface, etc. Such input devices may be connected to the processing circuitry 502 through the input device
interface 522 coupled to the system bus 506 but can be connected through other interfaces, such as a parallel port, an Institute of Electrical and Electronic Engineers (IEEE) 1394 serial port, a Universal Serial Bus (USB) port, an IR interface, and the like. The computer system 500 may include an output device interface 524 configured to forward output, such as to a display, a video display unit (e.g., a liquid crystal display (LCD) or a cathode ray tube (CRT)). The computer system 500 may include a communications interface 526 suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A fleet management system 100 for monitoring and managing carbon dioxide, CO2, emissions across a fleet of heavy-duty vehicles 110A, 110B, 110C, wherein the fleet management system 100 comprises a communication interface 230 configured for communication with the vehicles 110A, 110B, 110C, and computing circuitry 210 and a storage medium 220 for hosting a digital twin 110A', 110B', 110C' of each vehicle in the fleet, wherein each digital twin is configured to model CO2 emissions for its associated vehicle, and wherein the fleet management system is configured to: receive vehicle specifications and operating conditions from each vehicle 110A, 110B, 110C; determine a nominal CO2 emission level for each vehicle 110A, 110B, 110C by applying the vehicle specifications and the operating conditions of each vehicle to its digital twin 110A', 110B', 110C'; receive a measured CO2 emission level from each vehicle 110A, 110B, 110C; identify vehicles with elevated CO2 emission levels by comparing the nominal CO2 emission level with the measured CO2 emission level; and in response to a vehicle having elevated CO2 emissions determine one or more adjustive actions to reduce the CO2 emission level of the identified vehicle, and communicate said one or more adjustive actions to the identified vehicle.

Example 2: The fleet management system 100 of example 1, wherein the one or more adjustive actions comprise an instruction to the identified vehicle to reduce its CO2 emission level.

Example 3: The fleet management system 100 of any of examples 1-2, wherein the fleet management system is further configured to receive operating settings, the operating settings comprising at least one of vehicle speed, gearbox operation mode, gear shifting strategy, engine torque, cruise control settings, climate control settings, power take-off speed, and idle time settings, and wherein determining one or more adjustive actions comprises determining adjusted operating settings that reduce CO2 emission levels.

Example 4: The fleet management system 100 of any of examples 1-3, wherein determining the one or more adjustive actions comprises selecting one or more adjustive actions from a set of adjustive actions that are known to reduce CO2 emission levels.

Example 5: The fleet management system 100 of example 4, wherein the set of adjustive actions comprises limiting vehicle speed, mandating automatic mode in robotized gearboxes, activating eco-strategy gear shifting in robotized gearboxes, reducing engine torque, activating predictive cruise control, lowering climate control settings, decreasing power take-off speed, and reducing idle time.

Example 6: The fleet management system 100 of any of examples 1-5, wherein determining the one or more adjustive actions comprises identifying operating settings that contribute to the elevated CO2 emission value by applying the vehicle specifications, the operating conditions, and the nominal CO2 level to the digital twin.

Example 7: The fleet management system 100 of any of examples 1-6, wherein identifying vehicles with elevated CO2 emission levels comprises determining whether the measured CO2 emission level exceed the nominal CO2 emission level by a predetermined threshold value.

Example 8: The fleet management system 100 of any of examples 1-7, wherein the nominal CO2 emission level is set to ensure that the nominal CO2 emission level across the fleet of heavy-duty vehicles 110A, 110B, 110C collectively meet an aggregate CO2 emission limit.

Example 9: The fleet management system of any of examples 1-8, wherein: the vehicle specifications comprise at least one of vehicle chassis configuration, trailer configuration, vehicle weight, engine type, gearbox configuration, suspension system configuration, braking system configuration, and tire inflate system; the operating conditions comprise at least one of load weight, vehicle usage, route topography, tire pressure, engine coolant temperature, engine oil temperature, weather data, dust and particle levels.

Example 10: The fleet management system 100 of any of examples 1-9, wherein the digital twin comprises a machine learning model that is trained on a dataset comprising at least one of: vehicle specifications, operating conditions, and CO2 emission levels; and vehicle specifications, operating conditions, operating settings, and CO2 emission levels.

Example 11: The fleet management system 100 of any of examples 1-10, wherein the fleet management system is further configured to: receive operating settings; determine an expected CO2 emission level for each vehicle 110A, 110B, 110C by applying the vehicle specifications, the operating conditions, and the operating settings of each vehicle to its digital twin 110A', 110B', 110C'; detect a mismatch between an expected CO2 emission level and the measured CO2 emission level, and in response the mismatch request that the vehicle reports for vehicle service by sending a message from the fleet management system to the vehicle.

Example 12: A control unit 111A, 111B, 111C in a heavy-duty vehicle 110A, 110B, 110C configured for coordination with a fleet management system 100 wherein the fleet management system comprises a digital twin 110A', 110B', 110C' configured to determine a nominal CO2 emission level based on vehicle specifications and operating conditions of the heavy-duty vehicle 110A, 110B, 110C, and wherein the control unit 111A, 111B, 111C is configured to: obtain the vehicle specifications and the operating conditions of the heavy-duty vehicle; obtain a CO2 emission level from an exhaust system sensor 112A, 112B, 112C of the heavy-duty vehicle; send the vehicle specifications, the operating conditions and the measured CO2 emission level to the fleet management system 100, whereby the fleet management system 100 is configured to determine and communicate one or more adjustive actions in response to the measured CO2 emission level being elevated in comparison to the nominal CO2 emission level; receive the one or more adjustive actions; apply the one or more adjustive actions to the operating settings, thereby achieving a reduced CO2 emission level.

Example 13: The control unit 111A, 111B, 111C of example 12, wherein the one or more adjustive actions is an instruction to reduce CO2 emission level, and wherein applying the instruction, the control unit 111A, 111B, 111C is configured to select one or more adjustive actions from a set of adjustive actions that are known to reduce CO2 emission levels.

Example 14: A method for monitoring and managing carbon dioxide, CO2, emissions across a fleet of heavy-duty vehicles 110A, 110B, 110C, wherein the method utilizes a digital twin 110A', 110B', 110C' to model CO2 emissions of each vehicle in the fleet, and wherein the method comprises: receiving S1 vehicle specifications and operating conditions from each vehicle 110A, 110B, 110C; determining S2 a nominal CO2 emission level for each vehicle 110A, 110B, 110C by applying the vehicle specifications and the operating conditions of each vehicle to its digital twin 110A', 110B', 110C'; receiving S3 measured CO2 emission level from each vehicle 110A, 110B, 110C; identifying S4 vehicles with elevated CO2 emission levels by comparing the nominal CO2 emission level with the measured CO2 emission level; and in response to a vehicle having elevated CO2 emissions, determining S5 one or more adjustive actions to reduce the CO2 emission level of the identified vehicle, and communicating S6 said one or more adjustive actions to the identified vehicle.

Example 15: The method of example 14, wherein the one or more adjustive actions comprise an instruction to the identified vehicle to reduce its CO2 emission level.

Example 16: The method of any of examples 14-15, wherein receiving S1 further comprises receiving operating settings from each vehicle 110A, 110B, 110C, and wherein determining S5 one or more adjustive actions comprises determining adjusted operating settings that reduce CO2 emission levels.

Example 17: The method of any of examples 14-16, wherein determining S5 the one or more adjustive actions comprises selecting one or more adjustive actions from a set of adjustive actions that are known to reduce CO2 emission levels.

Example 18: The method of any of examples 14-17, wherein determining S5 the one or more adjustive actions comprises identifying operating settings that contribute to the elevated CO2 emission value by applying the vehicle specifications, the operating conditions, and the nominal CO2 level to the digital twin.

Example 19: The method of any of examples 14-18, wherein identifying S4 vehicles with elevated CO2 emission levels comprises determining whether the measured CO2 emission level exceed the target CO2 emission level by a predetermined threshold value.

Example 20: The method of any of examples 14-19, wherein the digital twin comprises a machine learning model that is trained on a dataset comprising at least one of: vehicle specifications, operating conditions, and CO2 emission levels; and vehicle specifications, operating conditions, operating settings, and CO2 emission levels.

Example 21: The method of any of examples 14-20, wherein the method further comprises: determining an expected CO2 emission level for each vehicle 110A, 110B, 110C by applying the vehicle specifications, the operating conditions, and the operating settings of each vehicle to its associated digital twin 110A', 110B', 110C'; detecting a mismatch between an expected CO2 emission level and the measured CO2 emission level, and in response to the detected mismatch request that the vehicle reports for vehicle service by sending a message from the fleet management system to the vehicle.

Example 22: A computer program 450 comprising program code means for performing the steps of any of examples 14-21 when said program is run on a computer or on processing circuitry 210, 410 of a control unit 100, 400.

Example 23: A computer readable medium 460 carrying a computer program 470 comprising program code means for performing the steps of any of examples 14-21 when said program product is run on a computer or on processing circuitry 410 of a control unit 100, 400.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A fleet management system (100) for monitoring and managing carbon dioxide, CO2, emissions across a fleet of heavy-duty vehicles (110A, 110B, 110C), wherein the fleet management system (100) comprises a communication interface (230) configured for communication with the vehicles (110A, 110B, 110C), and computing circuitry (210) and a storage medium (220) for hosting a digital twin (110A', 110B', 110C') of each vehicle in the fleet, wherein each digital twin is configured to model CO2 emissions for its associated vehicle, and wherein the fleet management system is configured to:
receive vehicle specifications and operating conditions from each vehicle (110A, 110B, 110C);
determine a nominal CO2 emission level for each vehicle (110A, 110B, 110C) by applying the vehicle specifications and the operating conditions of each vehicle to its digital twin (110A', 110B', 110C');
receive a measured CO2 emission level from each vehicle (110A, 110B, 110C),
identify vehicles with elevated CO2 emission levels by comparing the nominal CO2 emission level with the measured CO2 emission level; and
in response to a vehicle having elevated CO2 emissions determine one or more adjustive actions to reduce the CO2 emission level of the identified vehicle, and communicate said one or more adjustive actions to the identified vehicle.

2. The fleet management system (100) of claim 1, wherein the one or more adjustive actions comprise an instruction to the identified vehicle to reduce its CO2 emission level.

3. The fleet management system (100) of any of claims 1-2, wherein the fleet management system is further configured to receive operating settings, and wherein determining the one or more adjustive actions comprises applying the digital twin to identify operating settings that reduce CO2 emission levels.

4. The fleet management system (100) of any of claims 1-3, wherein determining the one or more adjustive actions comprises selecting one or more adjustive actions from a set of adjustive actions that are known to reduce CO2 emission levels.

5. The fleet management system (100) of any of claims 1-4, wherein identifying vehicles with elevated CO2 emission levels comprises determining whether the measured CO2 emission level exceed the nominal CO2 emission level by a predetermined threshold value.

6. The fleet management system (100) of any of claims 1-5, wherein the nominal CO2 emission level is set to ensure that the nominal CO2 emission level across the fleet of heavy-duty vehicles (110A, 110B, 110C) collectively meet an aggregate CO2 emission limit.

7. The fleet management system (100) of any of claims 1-6, wherein the digital twin comprises a machine learning algorithm that is trained on a dataset comprising at least one of:
vehicle specifications, operating conditions, and CO2 emission levels; and
vehicle specifications, operating conditions, operating settings, and CO2 emission levels.

8. The fleet management system (100) of any of claims 1-7, wherein the fleet management system is further configured to
receive operating settings,
determine an expected CO2 emission level for each vehicle (110A, 110B, 110C) by applying the vehicle specifications, the operating conditions, and the operating settings of each vehicle to its digital twin (110A', 110B', 110C'),
detect a mismatch between an expected CO2 emission level and the measured CO2 emission level, and in response the mismatch request that the vehicle reports for vehicle service by sending a message from the fleet management system to the vehicle.

9. A control unit (111A, 111B, 111C) in a heavy-duty vehicle (110A, 110B, 110C) configured for coordination with a fleet management system (100) wherein the fleet management system comprises a digital twin (110A', 110B', 110C') configured to determine a nominal CO2 emission level based on vehicle specifications and operating conditions of the heavy-duty vehicle (110A, 110B, 110C), and wherein the control unit (111A, 111B, 111C) is configured to:
obtain the vehicle specifications and the operating conditions of the heavy-duty vehicle;
obtain a CO2 emission level from an exhaust system sensor (112A, 112B, 112C) of the heavy-duty vehicle;
send the vehicle specifications, the operating conditions and the measured CO2 emission level to the fleet management system (100), whereby the fleet management system (100) is configured to determine and communicate one or more adjustive actions in response to the measured CO2 emission level being elevated in comparison to the nominal CO2 emission level;
receive the one or more adjustive actions;
apply the one or more adjustive actions to the operating settings, thereby achieving a reduced CO2 emission level.

10. The control unit (111A, 111B, 111C) of claim 9, wherein the one or more adjustive actions is an instruction to reduce CO2 emission level, and wherein applying the instruction, the control unit (111A, 111B, 111C) is configured to select one or more adjustive actions from a set of adjustive actions that are known to reduce CO2 emission levels.

11. A method for monitoring and managing carbon dioxide, CO2, emissions across a fleet of heavy-duty vehicles (110A, 110B, 110C), wherein the method utilizes a digital twin (110A', 110B', 110C') to model CO2 emissions of each vehicle in the fleet, and wherein the method comprises:
receiving (S1) vehicle specifications and operating conditions from each vehicle (110A, 110B, 110C);
determining (S2) a nominal CO2 emission level for each vehicle (110A, 110B, 110C) by applying the vehicle specifications and the operating conditions of each vehicle to its digital twin (110A', 110B', 110C');
receiving (S3) measured CO2 emission level from each vehicle (110A, 110B, 110C),
identifying (S4) vehicles with elevated CO2 emission levels by comparing the nominal CO2 emission level with the measured CO2 emission level; and
in response to a vehicle having elevated CO2 emissions, determining (S5) one or more adjustive actions to reduce the CO2 emission level of the identified vehicle, and communicating (S6) said one or more adjustive actions to the identified vehicle.

12. The method of claim 11, wherein the one or more adjustive actions comprise an instruction to the identified vehicle to reduce its CO2 emission level.

13. The method of any of claims 11-12, wherein receiving (S1) further comprises receiving operating settings from each vehicle (110A, 110B, 110C), and wherein determining (S5) one or more adjustive actions comprises applying the digital twin to identify operating settings that reduce CO2 emission levels.

14. The method of any of claims 11-13, wherein determining (S5) the one or more adjustive actions comprises selecting one or more adjustive actions from a set of adjustive actions that are known to reduce CO2 emission levels.

15. A computer readable medium (460) carrying a computer program (470) comprising program code means for performing the steps of any of claims 11-14 when said program product is run on a computer or on processing circuitry (410) of a control unit (100, 400).
